# EUROPEAN PATENT SPECIFICATION

(11) **EP 4 203 327 B1**
(45) Date of publication and mention of the grant of the patent: **19.08.2026**
(21) Application number: 21306922.2
(22) Date of filing: 23.12.2021
(51) Int. Cl.: H03M 13/25, H03M 13/27, H04L 1/00, H03M 13/13

(54) **OPTIMIZED DEVICE AND METHOD FOR TRANSMITTING CONTROL DATA**
OPTIMIERTE VORRICHTUNG UND VERFAHREN ZUR ÜBERTRAGUNG VON STEUERDATEN
DISPOSITIF OPTIMISÉ ET PROCÉDÉ DE TRANSMISSION DE DONNÉES DE CONTRÔLE

(43) Date of publication of application: 28.06.2023
(73) Proprietor: Eurecom, 06410 Biot (FR)
(72) Inventor: KNOPP, Raymond, 06410 BIOT (FR)
(74) Representative: Atout PI Laplace

(56) References cited:
- EP-A1- 3 955 482
- EURECOM ET AL: "Low-PAPR Sequence-Based Approaches", vol. RAN WG1, no. e-Meeting; 20201026 - 20201113, 13 November 2020 (2020-11-13), XP051954354, Retrieved from the Internet <URL:https://ftp.3gpp.org/tsg_ran/WG1_RL1/TSGR1_103-e/Docs/R1-2009451.zip R1-2009451 Low-PAPR Sequence-Based Approaches for PUCCH Coverage Enhancement.docx> [retrieved on 20201113]
- MAURIZIO MAGARINI ET AL: "Concatenated Coded Modulation for Optical Communications Systems", IEEE PHOTONICS TECHNOLOGY LETTERS, IEEE, USA, vol. 22, no. 16, 15 August 2010 (2010-08-15), pages 1244 - 1246, XP011311191, ISSN: 1041-1135
- QUALCOMM INCORPORATED: "Low PAPR Modulation", vol. RAN WG1, no. Prague, Czech Republic; 20170821 - 20170825, 20 August 2017 (2017-08-20), XP051316975, Retrieved from the Internet <URL:http://www.3gpp.org/ftp/Meetings_3GPP_SYNC/RAN1/Docs/> [retrieved on 20170820]

## Description

### TECHNICAL FIELD

The invention generally relates to digital communications and in particular to an optimized device and a method for transmitting control data.

### BACKGROUND

Mobile communication systems are progressing at an accelerated pace, in order to satisfy increasing demands in terms of real-time services and applications with higher capacities.

Mobile communication systems are rapidly progressing from a 4th generation (4G) mobile communication system to the future 5th generation (5G) mobile communication systems which are being standardized to provide rich, reliable and hyper-connected communications. In particular, 5G New Radio presents significant challenges.

A mobile communication system comprises a transmitter that transmits digital data comprising information symbols to one or more receivers through a transmission channel. The receiver receives and decodes the transmitted signal using a reverse processing as the one implemented at the transmitter. The digital data transmitted by the transmitter can comprise user data bits and control data bits.

The main existing transmission control data formats for 5G NR systems comprise uplink control channels, such as physical uplink control channel (PUCCH) and physical random access channel (PRACH). Control data can also be multiplexed or transmitted exclusively on the physical uplink shared channel (PUSCH). Different transmission formats exist for such control channels such as for example LTE/NR PUCCH formats 0, 1, 2, 3 and 4 considered in current 3GPP systems (LTE stands for "Long Term Evolution").

A significant challenge for improving the transmission of such control channel data is to provide the transmitter with a capacity of transmitting small payloads (around tens of bits) with low probability of error at very low signal-to-noise ratios.

Such challenge can be generally achieved both by optimizing the energy efficiency of the transmit waveform through:
- a minimization of the peak-to-average power ratio (PAPR), and
   - a design of strong structured coding strategies permitting low-complexity detection algorithms and coding gain compared to state-of-the-art solutions such as the 5G PUCCH Formats 3,4 with more than 11 bits.

Known solutions to reduce PAPR include peak windowing, scaling, and clipping. However, such approaches generate interference and distortions in the OFDM modulated signal which requires a further filtering to mitigate the interferences and distorsions, as described for example in EURECOM ET AL: "Low-PAPR Sequence-Based Approaches", 3GPP DRAFT; RI-2009451, 3RD GENERATION PARTNERSHIP PROJECT (3GPP).

Existing decoding algorithms used at the receivers to decode received signals corresponding to the current control channel formats (such as PUCCH) are based on sub-optimal reduced-complexity approaches. Such approaches consist of least-squares channel estimation based on the DMRS signals (DMRS stands for Demodulation Reference Signal) followed by quasi-coherent detection and soft-combining of repetitions from rate matching. These two operations yield soft-decisions for each of the coded bits. In the case of the RM code for example, a permutation is then applied to the 32 received soft-decisions to recuperate the bi-orthogonal structure of the code which is then amenable to reduced-complexity decoding via a fast Hadamard Transform as described in US8315185B2.

For the polar-coded case, the soft-decisions are passed to one of the reduced-complexity polar decoding algorithms as described in Fast List Decoders for Polar Codes by Gabi Sarkis, Pascal Giard, Alexander Vardy, Claude Thibeault, and Warren J. Gross, IEEE Journal on Selected Areas in Communications, VOL. 34, NO. 2, FEBRUARY 2016. In these two existing approaches, the algorithms are sub-optimal as the detection method uses separate channel estimation and quasi-coherent detection. Another possible solution would be to use a fully non-coherent receiver using the DMRS signals. However, such solution involves an increase in complexity, especially for a RM coded case with longer bit lengths.

There is accordingly a need for an improved transmission device and method capable of transmitting small payloads (short block lengths) with an optimized tradeoff between PAPR reduction and high coding gain.

### Summary of the invention

To address these and other problems, there is provided a transmitter device and a method of transmitting a digital input message as defined in the independent claims. Other features of the transmitter device are defined in the dependent claims.

### Brief description of the drawings

The accompanying drawings, which are incorporated in and constitute a part of this specification, illustrate various embodiments of the invention together with the general description of the invention given above, and the detailed description of the embodiments given below.
Figure 1 schematically represents an exemplary communication system implementing a transmitter according to some embodiments;
Figure 2 is a block diagram representing a transmitter, according to some embodiments of the invention;
Figure 3 is a block diagram representing the inner code modulation unit, according to some embodiments of the invention;
Figure 4 is a block diagram representing a non-coherent block code generator;
Figure 5 is a flowchart depicting a transmission method, according to some embodiment of the invention.

### Detailed description

Embodiments of the present invention provide a device and a method for transmitting control data that enable transmitting short block lengths and increase of the sensitivity of the receiver in order to provide enhanced coverage for control channels.

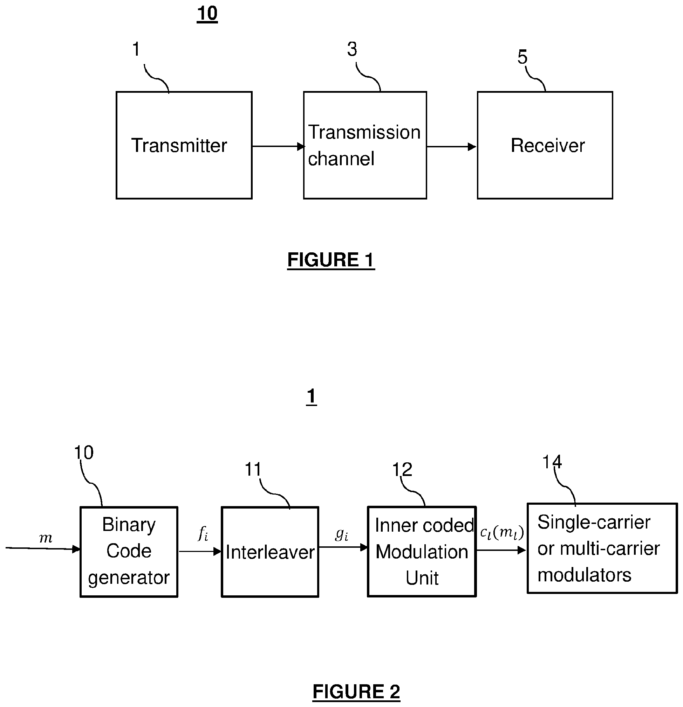

Figure 1 illustrates an exemplary communication system 10 in which embodiments of the invention can be implemented.

The communication system 10 may be for example a wireless communication system. The following description of embodiments of the invention will be made mainly with reference to a wireless communication system for illustration purpose although the skilled person will readily understand that the invention can also apply to other types of communication systems such as a wired system (for example optical fiber communication system).

The communication system 10 may comprise at least one transmitter device 1 (also referred to hereinafter as a "transmitter") configured to transmit a plurality of information symbols to at least one receiver device 5 (hereinafter referred to as "receiver") through a transmission channel 3.

The receiver 5 may be configured to receive the signal transmitted by the transmitter 1 and decode the received signal to recover the original data.

The transmission channel 3 (also called hereinafter "communication channel") may be any transmission channel adapted to transmit information symbols from the transmitter device 1 to the receiver device 5, depending on the type of the communication system, such as for example a wired connection channel, a wireless medium, an underwater communication channel, etc.

In an application of the invention to wireless communication systems such as ad-hoc wireless networks used in local area communications, wireless sensor networks and radio communication systems (e.g. LTE, LTE-advanced, 5G and beyond), the transmitter 1 and/or the receiver 5 may be any type of fixed or mobile wireless device configured to operate in a wireless environment.

The transmission channel 3 may be any wireless propagation medium adapted to such devices.

The transmitter 1 and/or the receiver 5 may be fixed or mobile and/or may be remotely monitored and/or controlled. The transmitter 1 and/or the receiver 5 may be equipped with power sources that provide power to the different components ensuring the operation of these devices (e.g. dry cell batteries, solar cells, and fuel cells).

The transmission channel 3 may represent any wireless network enabling loT. Exemplary wireless networks comprise low-power short range networks and LPWANs. Exemplary LPWAN technologies comprise LTE-NB1 and NB-loT.

Further, the transmission channel 3 may accommodate several pairs of transmitters 1 and receivers 5. In such embodiments, multiple access techniques and/or network coding techniques may be used in combination with error correction codes and modulation. Exemplary multiple access techniques comprise Time Division Multiple Access (TDMA), Frequency Division Multiple Access (FDMA), Code Division Multiple Access (CDMA), and Space Division Multiple Access (SDMA).

The transmission channel 3 may be a noisy channel. For example, the noise may result from the thermal noise of the system components and/or the intercepted interfering radiation by antennas. Other exemplary sources of noise comprise switching, manual interruptions, electrical sparks and lightning. In some embodiments, the total noise may be modeled by an additive white Gaussian noise (AWGN).

The transmission channel 3 may be a multipath channel using single-carrier or multi-carrier modulation formats such as OFDM (Orthogonal Frequency Division Multiplexing) for mitigating frequency-selectivity, interference and delays.

In some embodiments, data transmission in the communication system 10 may correspond to an uplink communication scenario during which the receiver 5 is configured to receive data from one or more transmitters 1 operating in a wireless environment. The receiver 5 may be a base station, a relay station, an eNodeB/gNodeB in a cellular network, an access point in a local area network or in ad-hoc network or any other interfacing device operating in a wireless environment. The transmitter 1 may be, without limitation, a mobile phone, a computer, a laptop, a tablet, a drone, an loT device etc.

According to some embodiments, the transmitter 1 and/or the receiver 5 may be equipped with a plurality of transmit and/or receive antennas. In such embodiments, space-time coding and/or space-time decoding techniques may be used in combination with coded modulations for encoding data both in the time and space dimensions, thereby exploiting space and time diversities of multiple antennas.

The receiver 5 can be also integrated in the base stations. The receiver 5 may be configured to receive a signal *y_{P}* transmitted by the transmitter 2 in a wireless channel. The channel may be noisy (for example channel with Additive White Gaussian Noise (AWGN) subjected to fading). The signal transmitted by the transmitter 1 may be further affected by echoes due to the multiple paths and/or the Doppler effect due to the transmitter and receiver having a non-zero relative velocity.

The transmitter 1 is configured for transmitting a digital input message m corresponding to control data used in a control channel through the communication channel 3.

According to some embodiments, the control data encoded at the transmitter 1 correspond to control data used in physical control channels such as uplink control channels.

Exemplary uplink physical control channels comprise PUCCH ('Physical Uplink Control Channels'), the control portion of PUSCH (Physical Uplink Shared Channel) and PRACH (Physical Random Access Channel). The Physical Random Access Channel (PRACH) may be used by an uplink user to contact a receiver (eNB base station for example).

Although the description will be made mainly with reference to uplink control channels such as PUCCH or the control portion of PUSCH, for illustration purpose, the skilled person will readily understand that the invention also applied to other uplink control channels. Exemplary PUCCHs comprise the LTE/NR PUCCH format 2 and the LTE/NR PUCCH formats 3 and 4 considered in current 3GPP systems.

The PAPR refers to a power characteristic that defines the average output power level of the power amplifier used in the transmitter 1 relative to the peak power. When the PAPR is high, the power amplifier of the transmitter 1 has to operate at a lower average power level. In contrast, a low PAPR enables the power amplifier at the transmitter to operate at a higher average power level with respect to the peak power. The PAPR of OFDM signals is defined as the ratio between the maximum instantaneous power and its average power.

Considering for example, a transmission of PUCCH data where the transmitted waveform makes use of prior information regarding synchronization with respect to the time window of the receiver 5 (for example a gNodeB), several PUCCH transmission formats in 5G NR can be used.

For example, PUCCH formats 1, 3 and 4 correspond to low-PAPR configurations with multiple-symbols. PUCCH format 0 has low PAPR but is not designed for coverage because of the limitation to transmission in 1 or 2 symbols and thus is energy-limited.

In prior art approaches, a message index corresponding to PUCCH format 0 control data is combined with a pseudo-random integer derived from system and user-specific parameters to select a low-PAPR quaternary sequence from a set of optimized sequences and to choose a cyclic time-shift of the selected sequence.

Format 2 has neither low-PAPR nor multi-symbol transmission for coverage and is used primarily in small-cell configurations.

Format 1 uses low-PAPR sequences similar to Format 0 but without a message dependent cyclic time-shift. In prior art approaches, the sequence for PUCCH format 1 is further modulated in amplitude depending on the 1 or 2 bit message and repeated across a number of symbols where *L_{DMRS}* is the number of so-called DMRS symbols used. The DMRS symbols are not message dependent and can be used by the receiver (gNodeB) to resolve channel uncertainty through explicit channel estimation or through other existing methods.

A prior art transmitter for transmission of PUCCH Format 3 and 4 use DFT-precoded QPSK or *π*/2-BPSK for low-PAPR rather than optimized quaternary sequences.

Similar to Format 1, Formats 3 and 4 also make use of 1, 2 or 4 DMRS which are similar payload-independent signals. A prior art transmitter for Formats 3 and 4, makes use, in terms of channel coding, of classical length 32 Reed-Muller codes for 3-11 bit payloads (3GPP Technical Specification 38.212 : [38212] NR; Multiplexing and Channel Coding, 3GPP Technical Specification, Release 16, V16.3, 2020-10-01). The 32-bit encoded bit stream is shortened or lengthened with rate-matching which amounts to truncation or repetition to fit the available resources.

The transmitter 1 according to the embodiments of the invention improves the probability of correct detection compared to such existing solutions, even in extreme coverage scenarios which are characterized by low signal-to-noise ratio.

Figure 2 represents a transmitter 1 corresponding to a concatenated coding Scheme, according to some embodiments.

The transmitter 1 is configured to transmit a digital input message m corresponding to control data used in a control channel through the communication channel 3. The control channel may be for example an uplink control channel such as PUCCH, a control component of PUSCH or PRACH.

Although the invention has particular advantages for downlink control channels, it should be noted that some aspects of the invention may be also applied to downlink control channels.

The input message m is defined as: $m = 0 , 1 , … {, 2}^{B} - 1$

In Equation (1), B represents the number of channel bits constituting the message m. The signal received at the receiver may be written as: ${r}_{p} = {H}_{p} x \left(m\right) + {z}_{p}$

In equation (2), **r***ₚ* represents the signal vector in *N* complex dimensions received on a receiver antenna port p, x(m) designates the *N*-dimensional modulated vector transporting *B* channel bits corresponding to the message *m*=0,1,..., 2*^{B}* - 1, and *zₚ* represents the additive white Gaussian noise having real and imaginary components being independent and have variance *σ*² in each dimension. Further, the matrix H*ₚ* is a *N* × *N* complex diagonal designating the complex value of the channel matrix representing the communication channel. The channel matrix H*ₚ* has arbitrary components unknown to the receiver.

In some embodiments, the modulated signal may satisfy ∥x(*m*)∥ *= c* ∀*m*, where c is an arbitrary constant.

In some embodiments, such as in the 3GPP 5G NR systems, the components of the modulated signal x(*m*) and the received signal r*ₚ* may represent samples in frequency and time.

The transmitter 1 is configured to transmit a digital input message m corresponding to control data used in a control channel (which may be an uplink control channel, such as for example PUCCH, PUSCH or PRACH) through the communication channel 3. The message *m* comprises *B* bits.

The transmitter 1 advantageously comprises:
- A binary code generator 10 configured to generate a binary code {*fᵢ*,*i* = 0,1, ..., *E'* - 1} from the *B* bits of the message, with *i* = 0, 1, ..., *E*' - 1; the binary code {*fᵢ,i* = 0, 1, ..., *E*' - 1} comprising E' bits : {*f*₁, *f*₂, ..., *f*_{*E'*-1}};
- A binary interleaver 11 configured to apply interleaving to the binary code *fᵢ*, which provides an interleaved binary code {*gᵢ*, *i* = 0,1, ..., *E* - 1}; the interleaved binary code {*gᵢ*, *i* = 0,1, ..., *E* - 1} comprises *E* bits : {*g*₁, *g*₂, ..., *g*_{*E*-1}};
- An inner coded modulation unit 12 configured to apply inner coded modulation to a message *mₗ* = 0,1, ..., 2*^{B'}* - 1 comprising *B'* bits taken from the interleaved binary code {*gᵢ*, *i* = 0,1, ..., *E* - 1}, which provides an inner modulation code *cₗ*(*mₗ*) comprising *K*-length inner coded modulated vectors *c_{k,l}* representing frequency-domain samples.

The inner modulation code *cₗ*(*mₗ*) (code sequence) is associated with a sequence index *l* with *l* = 0, 1, ..., *L -* 1. Each inner coded modulated vectors *c_{k,l}* is associated with an index *k* = 0, 1, ..., *K -* 1 and the index *l* = 0, 1, ..., *L -* 1.

*L* represents the number of inner coded-modulated sequences.

In one embodiment, the number of bits delivered by the binary code generator 10 and the interleaver 11 may be equal. To facilitate the understanding of the invention, the following description of some embodiments of the invention will be made mainly with reference to a number of bits *E'* delivered by the binary code generator 10 equal to the number of bits *E* delivered by the interleaver 11. Therefore, the notation *E* will be used to refer to both numbers so that the code output of the binary code generator 10 will be designated by *fᵢ, i* = 0,1, ... , E - 1 and the output of the binary interleaver 11 will be designated by *gᵢ, i* = 0,1, ... , *E* - 1.

The transmitter 1 further comprises single carrier or multi-carrier modulators 14, one modulator being associated with each transmit antenna. The single carrier or multi-carrier modulators 14 are configured to apply single carrier or a multi-carrier modulation to the code sequence *cₗ*(*mₗ*) provided by the inner coded modulation unit 12 and transmit a signal **x**(m) derived from the modulated sequence ***C**ₗ*(*mₗ*) over the communication channel 3 using the transmit antennas.

The modulated sequence ***C**ₗ*(*mₗ*) may be equal to x(m), if no modulation component is used for PAPR reduction.

The inner coded modulation unit 12 may advantageously use a non- coherent code.

Accordingly, the transmission scheme is based on a serial concatenation of a binary code generator 10, a binary interleaver 11, and an inner code modulation unit 12.

Each single carrier or multi-carrier modulator 14 is configured to convert the constructed codeword or vector of spatially multiplexed symbols from the time domain to the frequency domain using a single carrier or a multi-carrier modulation technique. Exemplary multi-carrier modulation techniques comprise OFDM and FBMC (filter-bank Multi-Carrier).

In embodiments using OFDM, the single carrier or multi-carrier modulators 14 are OFDM modulators (OFDM stands for Orthogonal Frequency-Division Multiplexing) configured to apply OFDM modulation the combined sequence.

The following description of some embodiments of the invention will be made mainly with reference to OFDM modulation using OFDM modulators for illustration purpose only although the invention applies to other types of single-carrier or multi-carrier modulation.

The single-carrier or multi-carrier modulators 14 are configured to convert the modulated symbols from the time domain to the frequency domain using a multicarrier modulation technique and spread the signals thus obtained over the nₜ transmission antennas of the transmitter 1, each transmission antenna being associated with a single-carrier or multi-carrier modulator 14.

Signals may be sent from the transmit antennas optionally after filtering, frequency transposition and amplification by at least one power amplifier provided at the transmitter 1.

The symbols of the vector x(m) may represent samples in both time and frequency. In particular, the frequency dimensions may be adjacent carriers in a multi-carrier modulation symbol (OFDM symbol for example) and the time dimensions may refer to different modulation symbols. In general, a time or frequency dimension is designated by a Resource Element.

The number of dimensions of the received signal yₚ will be denoted *N.*

*S* represents the number of modulation symbols on which the information is spread and *K* representing the minimal number of physical resource blocks (modulation carriers such as OFDM carriers).

*S* divides N=KL.

*α* = *N*/*S* may be a multiple of 12 for a 3GPP application of the invention.

The number of dimensions per symbol is equal to LK/S (which is for example a multiple of *α* (with *α* =12 for a 3GPP application).

As used herein, a Resource Element (RE) refers to the smallest defined unit consisting of one sub-carrier during one modulation symbol interval. Each Resource Block (RB) designates a number of Resource Elements (RE). Resource blocks (RB) are used to map physical channels to resource elements RE.

In a 3GPP application of the invention, the integer *α* is equal to 12. Accordingly, each resource block contains 12 complex dimensions or resource elements over which coding is performed. In such 3GPP application, *K* may be chosen in the range of 1 to 16 for example. Further, the number of symbols *S* may be chosen in the range of 1 to 14 symbols for example, or may be more important if multiple slots are used to signal the *B* bits.

The following description will be made mainly with reference to the number of signaling dimensions per vector *αK* equal to 12*K* (*α =* 12) used in a 3GPP OFDM embodiment. However, the skilled person will readily understand that the invention is not limited to such value of *αK* and similarly applies to any number of dimensions.

In one embodiment, the number *E* of bits delivered by the binary code generator and the interleaver may be equal: $E = B ′ L$

The transmitter 1 may further comprise a space-time encoder (not represented) for delivering a code word using a space time code before performing OFDM modulation. The space-time encoder may be configured to perform space-time coding or spatial multiplexing in embodiments in which the transmitter 1 is equipped with a plurality of transmit antennas.

It should be noted that there are no demodulation reference signals (DMRS) required in such transmission scheme.

In one embodiment, the binary code generated by the binary code generator 10 may be a 3GPP polar code.

Although the invention has particular advantages with a binary code generator 10 generating a 3GPP polar code, the skilled person will readily understand that the invention is not limited to a polar code and may apply to other binary codes such as LDPC codes, turbo codes, convolutional codes, tail-biting convolutional codes, binary block codes.

In some embodiments, such as embodiments using 3GPP polar code, the binary code generator 10 may be configured to generate an initial binary code comprising *N* bits. The binary code generator 10 may comprise a converter (implementing a polar rate-matching method) for converting the *N_{c}* generated binary (*N_{c}* = 2*ⁿ*) coded bits of the initial binary code into *E* bits which are input to the interleaver 12.

The *E* bits thus obtained are then input to the interleaver 102 prior to the inner coded modulation unit 12.

The input *mₗ* = 0,1, ..., 2*^{B'}* - 1 to the inner coded modulation is of dimensionality *B'* bits taken in order from the sequence at the output of interleaver *gᵢ, i* = 0,1, ..., *E* - 1, which generates *K* frequency-domain samples.

In some embodiments, the interleaver 12 may be configured to ensure that *E*/*B'* adjacent coded bits in the binary code are spread regularly across *E*/*B'* different vectors of the inner modulation code.

For example, in embodiment using a binary code generator 10 generating a Polar code, the binary interleaver 11 is configured to ensure that adjacent polar coded bits are spread regularly across inner code sequences so as to guarantee that E/B' adjacent polar coded bits are spread in E/B' different codewords of the inner modulation code.

In one embodiment, the interleaver 11 may be configured to implement a mapping of the coded bits provided by the binary code generator 10 to a low-PAPR sequence, the mapping being defined by a mapping function *f*() such as each component *gᵢ* of index i of the interleaved binary code is equal to: ${g}_{i} = {f}_{\left(iB′modE\right) + \left⌊i/\left(\frac{E}{B ′}\right)\right⌋}$

The *E*/*B'* -bit representation of *E*/*B'* adjacent output bits from the *gᵢ* sequence in symbol *l* is defined by *mₗ* ∈ {0,1, ..., 2*^{B'}* - 1}.

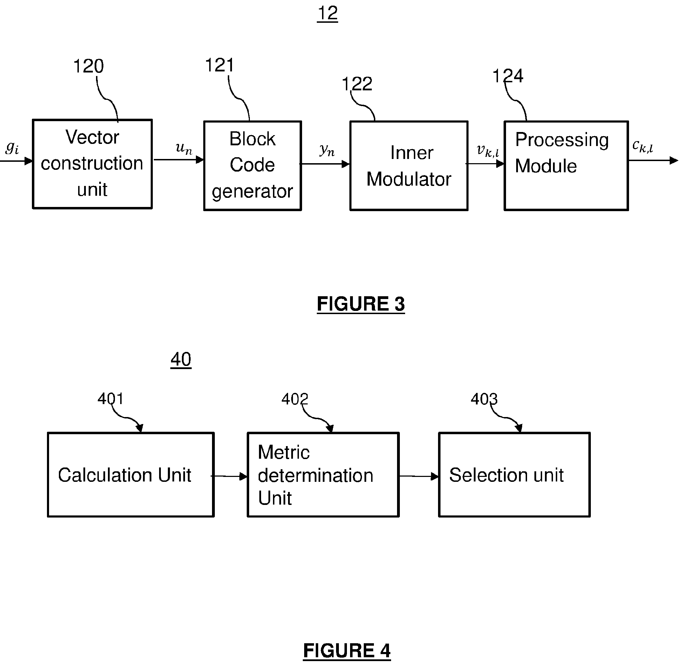

Figure 3 is a diagram of the inner coded modulation unit 12, according to some embodiments.

As shown in Figure 3, the inner coded modulation unit 12 comprises a vector construction unit 120 configured to create *B*'-bit information vectors **u***ₙ* from interleaved binary code bits *gₗ*, and a block code generator 121 configured to generate a non-coherent code from the received B' bits and the parameter *K*.

The non-coherent code represents a modulated sequence of *K* samples, the *K* samples being complex number determined from a given alphabet.

The block code generator 121 may be a M-ary block code generator comprising a code generator using a generator matrix *G*(*K,B'*) configured to generate the non-coherent code.

In some embodiments, the M-ary block code generator 120 may be configured to determine the non-coherent code as a codeword $\left⌊{m 2}^{- B ′}\right⌋$ from a (B', K) linear error correcting code, having a length *B'* and a rank *K.*

The alphabet used by the non-coherent block code generator 121 may be a root-of-unity alphabet, such as a QPSK or BPSK alphabet.

In embodiments using a BPSK alphabet, the input and the output of the M-ary block code generator and the generator matrix elements may be binary. The arithmetic operations used by the block code generator 121 (such as additions, subtractions and multiplications) to generate the code sequence ***y**ₗ* may then be operations modulo 2.

In embodiments using a QPSK alphabet, the input of the M-ary block code generator may be binary, and the M-ary block code generator 121 may transform the received input to integers modulo 4. The arithmetic operations used by the block code generator 121 to generate the coded ***y**ₙ* (such as additions, subtractions and multiplications) may then be operations modulo 4.

The inner coded modulation unit therefore takes the B' input bits and provides them to the M-ary block code with generator 121 which uses the generator matrix *G*(*K, B'*) to generate the non-coherent code.

The M-ary block code generator 121 is configured to generate an *K-*dimensional coded vector **y***ₗ* as: ${y}_{l} = {u}_{l} ′ G$

Advantageously, the vector u*ₗ'* depends on u*ₗ* (which means that u*ₗ'* is determined from u*ₗ*).

In embodiments using a BPSK alphabet, the vector **u***ₗ'* may be defined as: ${u}_{l} ′ = {u}_{l}$

Alternatively, in embodiments using a QPSK alphabet, for even values of *B'*, the vector **u***ₗ'* may be defined as: ${u}_{l} ′ \left(i\right) = 2 {u}_{l} \left(2i\right) + {u}_{l} \left(2i+1\right) , 0 \leq i < \frac{B ′}{2}$

Further, in embodiments using a QPSK alphabet, but for odd values of *B*', the vector **u***ₗ'* is defined as: ${u}_{l} ′ \left(i\right) = \left\{\begin{matrix}2 {u}_{l} \left(2i\right) + {u}_{l} \left(2i+1\right) , & 0 \leq i < \left⌊\frac{B ′}{2}\right⌋ \\ 2 {u}_{l} \left(2i\right) & i = \left⌊\frac{B ′}{2}\right⌋\end{matrix}\right.$

The inner coded modulation unit 12 may further comprises an inner modulator 122 configured to modulate each coded vector **y***ₗ* to provide a *K*-dimensional modulated coded vector c*ₗ*, the modulated coded vector c*ₗ* being determined from the coded vector **y***ₗ*.

In embodiments using a BPSK alphabet, the modulated coded vector y*ₗ* may be determined as: ${c}_{l , k} = 2 {y}_{l , k} - 1$

Or equivalently: ${c}_{l , k} = 1 - 2 {y}_{l , k}$

In equation (9) and (10), the index *k* = 0,1, ... , *K -* 1.

Alternatively, in embodiments using a QPSK alphabet, the modulated coded vector y*ₗ* may be determined as: ${c}_{l , k} = {e}^{γ \sqrt{- 1}} \sqrt{{\left(-1\right)}^{{y}_{l , k}}}$

In equation (11), *γ* is an arbitrary real constant and *k* = 0,1, ... , *K* - 1*.* The parameter *α* need not be known to the receiver 5.

Accordingly, the inner modulator 122 is configured to modulate the coded vector yielding the *K*-dimensional vector **c***ₗ*.

The inner coded modulation unit 12 may further comprise a processing module 124 configured to group *K' = KL*/*S* adjacent samples *c_{l,k}* to determine intermediary vectors *v_{k',s}* of length *L* samples, with *k' =* 0,1, *... , K'* - 1, *s* = 0,1, ... , *S* - *1. K*' need not be a multiple of *K.*

The processing module 124 may be further configured to determine the inner coded modulated vectors *d_{k',s}*, each vector *d_{k',s}* being determined from the corresponding intermediary vector *v*_{*k'*,*s*} and a phasor term *φₖ*, which depends on *k'.*

In one embodiment, the inner coded modulated vector *c_{k,l}* may be defined as: ${d}_{k ′ , s} = {v}_{k ′ , s} {φ}_{k ′}$

In some embodiments, the phasor term *φₖ* may be defined as: ${φ}_{k ′} = {e}^{jβk ′ mod 2}$

Through an appropriate choice of β, The phasor *φ_{k'}* is used to avoid zero-crossings prior to a DFT (Discrete Fourier Transform) precoding.

In some embodiment, the intermediary vector *v_{k',s}* may be defined as: ${v}_{k ′ , s} = {c}_{\left⌊\frac{k ′ + sK ′}{K}\right⌋ , \left(k′+sK′\right) mod K}$

In equation (14), *k'* = 0,1, *... , K'* - 1 and *s* = 0,1, ... , *S* - 1.

The *c_{k,l}* or *v_{k',s}* outputs are time-domain outputs.

The single-carrier ou multi-carrier modulators 14 are configured to transform each inner coded modulated vectors *v_{k',s}* from the time domain to the frequency domain using L-Discrete Fourier Transform (L-DFT) processing, which provides a modulated output vector ***C**_{k',s}*, the modulated sequence (***C**ₗ*(*mₗ*)) delivered by the single-carrier or multi-carriers modulators 14 comprising the modulated output vectors (***C**_{k,l}*).

The tuple (*k',s*) corresponds to a modulation subcarrier *k'* and a modulation symbol *s* (for example OFDM subcarrier and OFDM symbol).

In one embodiment, the one or more single-carrier or multi-carrier modulators 14 are configured to determine the modulated output vector ***C**_{k',s}* as: ${C}_{k ′ , s} = \frac{1}{\sqrt{K ′}} {\sum }_{k " = 0}^{K ′ - 1} {v}_{k " , s} {e}^{- 2 π \sqrt{- 1} k " k ′ / K ′}$

In equation (15), with *k*' designates a modulation subcarrier and *s* a modulation symbol and *K*' the number of non-zero OFDM carriers per symbol.

In one embodiment, the M-ary block code generator 121 may be configured to determine the non-coherent code **c***ₙ* as a codeword $\left⌊{m 2}^{- B ′}\right⌋$ from a (B', K) linear error correcting code, having a length *B'* and a rank *K* represented by a generator matrix *G*(*B', K*) given in a systematic form: $G \left(B′,K\right) = \left({I}_{K} {G}_{K \times \left(B′\right) - K}\right)$

In equations (16), *I_{K}* designates the identity matrix of dimensions *Kx K, G*_{*K* x *B'*-*K*} designates a rectangular matrix comprising *K* lines or row vectors and *BV - αK* columns or column vectors, and *G*_{*L* x *BH-L*} each designates a rectangular matrix comprising *L* lines or row vectors and *B' - K* columns or column vectors. The linear error correcting code may be generated for example as described in EP application N°20305929.0.

EP N°20305929.0 describes a device for determining such linear error correcting code.

Figure 4 illustrates the steps performed to generate the linear error correcting code according to EP N°20305929.0.

As shown in figure 4, the device 40 for determining the linear error correcting code comprises:
- a calculation unit 401 configured to determine two or more candidate generator matrices, each candidate generator matrix defining a linear error correcting code and comprising values selected from a predefined set of values, each candidate generator matrix providing a set of codeword vectors from input vectors, the input vectors comprising values selected from the predefined set of values;
- a metric determination unit 402 configured to associate a vector metric to each pair of codeword vectors provided by each candidate generator matrix for a predefined modulation scheme and to associate a matrix metric to each candidate generator matrix, a matrix metric associated with a candidate generator matrix being the minimum value among the vector metrics associated with the pairs of codeword vectors provided by the candidate generator matrix;
- a selection unit 403 configured to select the one or more candidate generator matrices that are associated with the highest matrix metric among the two or more candidate generator matrices.

The linear error correcting code generated is represented by the selected one or more candidate generator matrices.

The selection unit 403 is configured to select, among the one or more candidate generator matrices associated with the highest matrix metric, the candidate generator matrix that is associated with the highest matrix metric and that provides a minimum number of pairs of codeword vectors that are associated with a vector metric equal to the highest matrix metric, these pairs of codeword vectors comprising a zero-valued codeword vector and a non-zero valued codeword vector.

The calculation unit 401 may be configured to previously determine a first set of candidate generator matrices comprising two or more candidate generator matrices and to determine at least one candidate generator matrix from the first set of candidate generator matrices.

The calculation unit 401 may be configured to determine extended codeword vectors from the codeword vectors provided by the selected one or more candidate generator matrices using a code extension by applying a complex or a real Hadamard matrix of one or more codes.

Each pair of codeword vectors may comprise a first codeword vector and a second codeword vector, the calculation unit 401 being configured to determine a first value by mapping the first codeword vector using the predefined modulation scheme and to determine the second value by mapping the second candidate vector using the predefined modulation scheme, the metric determination unit 402 being configured to determine the vector metric associated with each pair of codeword vectors as the absolute value of the pairwise correlation between the first value and the second value.

The linear error correcting code may be M-ary code such as a binary or a quaternary or a 4-ary code.

Advantageously, the generator matrix **G**(*K, B*') may be in the form: $G \left(K,B′\right) = \left(\begin{matrix}1 & 0 & 0 & … & 0 & {g}_{0 , 0} & ⋯ & {g}_{0 , K - B ′ - 1} \\ 0 & 1 & 0 & ⋯ & 0 & {g}_{1 , 0} & … & {g}_{1 , K - B ′ - 1} \\ 0 & 0 & 1 & ⋯ & 0 & {g}_{2 , 0} & … & {g}_{2 , K - B ′ - 1} \\ ⋮ & ⋮ & ⋯ & ⋱ & 0 & ⋮ & ⋮ & ⋮ \\ 0 & 0 & 0 & 0 & 1 & {g}_{B ′ - 1 , 0} & … & {g}_{B ′ - 1 , K - B ′ - 1}\end{matrix}\right)$

The generator matrix **G**(*K*, *B*') is used to produce a modulated sequence of K samples.

In an example using OFDM modulators 14, considering that B' = 6 and *K* = 12 so that each group of six bits taken from the output of the interleaver 12 are used to generate one full PRB (Physical Resource Block) from a single OFDM symbol, the generator matrix G(12,6) used to generate the non-coherent code is for example: $G \left(12, 6\right) = \left[\begin{matrix}1 & 0 & 0 & 1 & 2 & 2 & 3 & 3 & 3 & 3 & 3 & 3 \\ 0 & 1 & 0 & 3 & 2 & 3 & 1 & 2 & 3 & 3 & 3 & 3 \\ 0 & 0 & 1 & 2 & 1 & 2 & 2 & 2 & 0 & 1 & 2 & 3\end{matrix}\right]$

In another example, a simpler inner code can be obtained with *B' =* 4, *K* = 6, so that each group of four bits taken from the output of the interleaver 12 are used to generate one half PRB from a single OFDM symbol, using the generator matrix **G**(6,4): $G \left(6, 4\right) = \left[\begin{matrix}1 & 0 & 0 & 0 & 2 & 3 \\ 0 & 1 & 2 & 0 & 3 & 0\end{matrix}\right]$

In some embodiments, the vector construction unit 120 may be configured to create the *B*'-bit information vectors **u***ₗ* from the interleaved binary code bits *gₗ* having an index *l* such that: $l = n \left⌊\left(\frac{E}{B ′}\right)\right⌋ , 1 + n \left⌊\left(\frac{E}{B ′}\right)\right⌋ , … , \left(n+1\right) \left⌊\left(\frac{E}{B ′}\right)\right⌋ - 1$ (as *L* = *E*/*B'* or *N*/*K*).

It should be noted that the receiver 5 implements a reverse processing of the processing implemented in transmission.

One particular implementation of the invention and Log-Likelihood Ratio (LLR) generation for the *B'* bits in OFDM symbol *l* is: $\begin{matrix}{λ}_{l , n} = \\ {max}_{m = 0 , 1 , … {, 2}^{B ′} - 1 s . t . \left(m{2}^{- n}\right) = 1} {\sum }_{p = 0}^{P - 1} {\left|{\sum }_{k = 0}^{11} {y}_{l , p} {c}_{l}^{H} \left(m\right)\right|}^{2} - \\ {max}_{m = 0 , 1 , … {, 2}^{B ′} - 1 s . t . \left(m{2}^{- n}\right) = 0} {\sum }_{p = 0}^{P - 1} {\left|{\sum }_{l = 0}^{11} {y}_{l , p} {c}_{l}^{H} \left(m\right)\right|}^{2} , l = 0 , 1 , … , L - 1 , n = 0 , 1 , … , B ′ - \\ 1\end{matrix}$

λ*_{l,n}* denotes the max-log-map approximation for the log-likelihood ratio of a particular bit and assumes that the likelihood function is well-approximated by an exponential which is close to being the case depending on the channel model assumptions used in the receiver 5.

In practice, the log-likelihoods may not be simple linear functions of the quadratic forms given in (18). To avoid sub-optimality, a tighter approximation of the true LLR can be used.

After applying the detection rule to obtain LLRs, they are deinterleaved and fed to the channel decoder input.

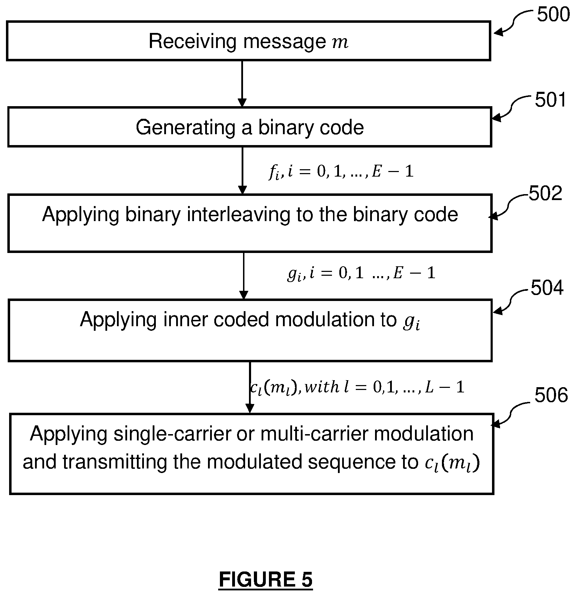

Figure 5 is a flowchart representing a method of transmitting a digital input message corresponding to control data used in an control channel (for example uplink control channel such as PUCH, PUSCH or PRACH) through a communication channel, the message m comprising a number B of bits.

In step 500, a binary code (*fᵢ, **i*** = 0,1, ... , *E'* - 1) is generated from the message.

In step 502, interleaving is applied to the binary code, which provides the interleaved binary code (*gᵢ, i* = 0,1, ... , *E* - 1).

In step 503, the inner coded modulation is applied to the message *mₗ* = 0,1, ... , 2^{*B*'} - 1 comprising *B'* bits taken from the interleaved binary code (*gᵢ*), which provides the inner modulation code comprising the *K* inner coded modulated vectors (*c*_{*k*,*l*}(*mₗ*)) representing frequency-domain samples.

In step 504, a single-carrier or multi-carrier modulation may be applied to the the inner modulation code obtained in step 503, and a signal x(m) obtained from the modulated sequence *Cₗ*(*mₗ*) may be then transmitted over the communication channel 3 using the transmit antennas.

The embodiments of the invention accordingly rely on concatenated schemes that advantageously can use low-spectral efficiency and/or short block length coding (typically inferior to 24 bits) optimized for non-coherent metric with powerful binary coding, such as 3GPP Polar code, 3GPP Turbo code, 3GPP LDPC code, tail-biting convolutional code, etc.. They enable increasing the sensitivity of the receivers in order to provide enhanced coverage for control channels (for example PUCCH and PUSCH Uplink channels).

The embodiments of the invention provide more coding gain while maintaining a moderate PAPR.

The communication system 10 according to the embodiments of the invention may be used in various applications such as Machine-To-Machine (M2M), Web-of-Things (WoT), and Internet of Things (IoT) (for example vehicle-to-everything V2X communications) involving networks of physical devices, machines, vehicles, home alliances and many other objects connected to each other and provided with a connectivity to the Internet and the ability to collect and exchange data without requiring human-to-human or human-to-computer interactions.

For example, in loT applications, the communication system 10 may be a wireless network, for example a wireless loT/M2M network representing low energy power-consumption/long battery life/low-latency/low hardware and operating cost/high connection density constraints such as low-power wide area networks and low-power short-range loT networks. Exemplary technologies used in such applications may comprise 5G, LTE-NB1 (Long Term Evolution-Machine to Machine, Narrow Band) and NB-loT (NarrowBand loT).

The communication system 10 may be used in various consumer, commercial, industrial, and infrastructure applications. Exemplary consumer applications comprise connected vehicles (Internet of Vehicles loV), home automation/smart home, smart cities, wearable technology, and connected health. Exemplary commercial applications comprise medical and healthcare and transportation. In the medical field, a digitized healthcare system connecting medical resources and healthcare services may be used in which special monitors and sensors are used to enable remote health monitoring and emergency notification. Exemplary industrial applications comprise applications in agriculture, for example in farming using sensors, to collect data on temperature, rainfall, humidity, wind speed, and soil content. Exemplary infrastructure applications may comprise the use of IoT devices to perform monitoring and controlling operations of urban and rural infrastructures such as bridges and railway tracks.

The transmitter 1 and/or the receiver 5 may be any physical internet-enabled device/object provided with required hardware and/or software technologies enabling communication over Internet. The transmitter 1 and/or the receiver 5 may be any standard internet connected-devices such as desktop computers, servers, virtual machines laptops, smart-phones, tablets. In some applications, the transmitter 1 and/or the receiver 5 may be any loT/M2M device or connected device operating in an loT/M2M network such as medical devices, temperature and weather monitors, connected cards, thermostats, appliances, security devices, drones, smart clothes, eHealth devices, robots, and smart outlets.

Embodiments of the present invention can take the form of an embodiment containing software only, hardware only or both hardware and software elements.

Furthermore, the methods described herein can be implemented by computer program instructions supplied to the processor of any type of computer to produce a machine with a processor that executes the instructions to implement the functions/acts specified herein. These computer program instructions may also be stored in a computer-readable medium that can direct a computer to function in a particular manner. To that end, the computer program instructions may be loaded onto a computer to cause the performance of a series of operational steps and thereby produce a computer implemented process such that the executed instructions provide processes for implementing the functions specified herein.

It should be noted that the functions, acts, and/or operations specified in the flow charts, sequence diagrams, and/or block diagrams may be re-ordered, processed serially, and/or processed concurrently consistent with embodiments of the invention. Moreover, any of the flow charts, sequence diagrams, and/or block diagrams may include more or fewer blocks than those illustrated consistent with embodiments of the invention.

While embodiments of the invention have been illustrated by a description of various examples, and while these embodiments have been described in considerable detail, it is not the intent of the applicant to restrict or in any way limit the scope of the appended claims to such detail.

In particular, although the invention has particular advantages in embodiments using OFDM modulation, the invention also applies to other type of single-carrier and multi-carrier modulation.

Additional advantages and modifications will readily appear to those skilled in the art. The invention in its broader aspects is therefore not limited to the specific details, representative methods, and illustrative examples shown and described, but it is defined by the appended claims.

## Claims

1. A transmitter device (1) for transmitting a digital input message m corresponding to control data used in a control channel through a communication channel (3), the transmitter device (1) comprising a set of transmit antennas, the message comprising a number *B* of bits, said transmitter device comprising:
- a binary code generator (10) configured to generate a binary code sequence from the *B* bits of the message, said binary code sequence comprising *E'* coded bits *fᵢ*;
- a binary interleaver (11) configured to apply interleaving to said binary code sequence, which provides an interleaved binary code comprising *E* bits *gᵢ* with *i* = 0, 1 ... , *E* - 1;
- an inner coded modulation unit (12) configured to apply inner coded modulation to a *B*'-bit information vector *uₗ* = 0,1, ... , 2*^{B'}* - 1, *l* = 0,1, *... , L -* 1, comprising *B'* bits taken from the interleaved binary code sequence *cₗ*, to provide a K-dimensional inner modulation code sequence comprising inner coded modulated vectors *c*_{*l*,*k*}, with *k* = 0,1, *... , K -* 1*,* representing frequency-domain samples, said B'-bit information vector *uₗ* corresponding to a message *mₗ* = 0,1, ..., 2*^{B'}* - 1;
- one or more modulators (14) configured to apply single-carrier or multi-carrier modulation to the inner modulation code sequence *cₗ* to provide a modulated sequence x(m), the transmitter device being configured to transmit said modulated sequence over the communication channel using said transmit antennas,
wherein the inner coded modulation unit (12) comprises a vector construction unit (110) configured to create said *B*'-bit information vector u*ₗ* from the interleaved binary code bits *gᵢ*, and a block code generator (121) configured to generate a non-coherent code sequence **y***ₗ* from the *B*'-bit information vector u*ₗ* and the parameter *K*, said non-coherent code **y***ₗ* representing a modulated sequence of *K* samples, said *K* samples being complex numbers determined from a given alphabet,
**characterised in that**
the vector construction unit (110) is further configured to create the *B*'-bit information vector **u***ₗ* by taking the *B*' bits in order from the sequence *gᵢ* at the output of the binary interleaver (11) and the block code generator (121) is configured to generate the non-coherent code sequence as : ${y}_{l} = {u}_{l} ′ G$
where **u***ₗ'* depends on **u*ₗ*** and G represents a generator matrix of a non-coherent block code.

2. The transmitter device (1) of claim 1, wherein the binary interleaver (11) is configured to ensure that E/B' adjacent coded bits in the binary code sequence are spread regularly across E/B' different vectors of the inner modulation code.

3. The transmitter device (1) of claim 2, wherein a bit *gᵢ* of the interleaved binary code sequence is determined as: ${g}_{i} = {f}_{\left(iB′modE\right) + \left⌊i/\left(\frac{E}{B ′}\right)\right⌋} ,$

4. The transmitter device (1) of any preceding claim, wherein the alphabet is a root-of-unity alphabet, such as a QPSK alphabet or a BPSK alphabet.

5. The transmitter device (1) of any preceding claim, wherein the alphabet is a BPSK alphabet, and the vector **u***ₗ'* is defined as: ${u}_{l} ′ = {u}_{l}$

6. The transmitter device (1) of any preceding claims 1 to 4, wherein the alphabet is a QPSK alphabet, and wherein, for even values of *B'*, the vector **u***ₗ'* is defined as: ${u}_{l} ′ \left(i\right) = 2 {u}_{l} \left(2i\right) + {u}_{l} \left(2i+1\right) ,$ with $0 \leq i < \frac{B ′}{2} .$

7. The transmitter device (1) of any preceding claims 1 to 4, wherein the alphabet is a QPSK alphabet, and wherein, for odd values of *B*', the vector **u***ₗ'* is defined as: ${u}_{l} ′ \left(i\right) = \left\{\begin{matrix}2 {u}_{l} \left(2i\right) + {u}_{l} \left(2i+1\right) , & 0 \leq i < \left⌊\frac{B ′}{2}\right⌋ \\ 2 {u}_{l} \left(2i\right) & i = \left⌊\frac{B ′}{2}\right⌋\end{matrix}\right.$

8. The transmitter device (1) of any preceding claim, wherein the inner coded modulation unit (12) further comprises a inner modulator (122) configured to modulate each coded vector **y***ₗ* to provide said *K*-dimensional inner modulation code sequence c*ₗ*, the *K*-dimensional inner modulation code sequence c*ₗ* being determined from the non-coherent code sequence **y***ₗ*.

9. The transmitter device (1) of claim 8, wherein the alphabet is a BPSK alphabet and the inner coded modulated vectors *c_{l,k}* of the *K*-dimensional inner modulation code sequence c*ₗ* are determined as: ${c}_{l , k} = 2 {y}_{l , k} - 1 ,$ or ${c}_{l , k} = 1 - 2 {y}_{l , k} ,$ with $k = 0 , 1 , … , K - 1$

10. The transmitter device (1) of claim 8, wherein the alphabet is a QPSK alphabet and the inner coded modulated vectors *c_{l,k}* of the *K*-dimensional inner modulation code sequence c*ₗ* are determined as: ${c}_{l , k} = {e}^{γ \sqrt{- 1}} \sqrt{{\left(-1\right)}^{{y}_{l , k}}} ,$ where *γ* is a real constant and *k =* 0,1, *... , K -* 1.

11. The transmitter device (1) of any preceding claim 8 to 10, wherein the inner coded modulation unit (12) further comprises a processing module (124) configured to:
- group *K' = KL*/*S* adjacent samples *c_{l,k}* to determine intermediary vectors *v*_{*k'*,*s*} of length *L* samples, with ' = 0,1, ... , *K'* - 1 and *s* = 0,1, ... , *S* - 1;
- determine the inner coded modulated vectors *c_{l,k}* from the corresponding intermediary vector *v*_{*k'*,*s*} and a phasor term *φ_{k'}* which depends on *k'.*

12. The transmitter device (1) of claim 11, wherein the intermediary vector *v*_{*k*',*l*} is defined as: ${v}_{k ′ , s} = {c}_{\left⌊\frac{k ′ + sK ′}{K}\right⌋ , \left(k′+sK′\right) mod K}$

13. A method of transmitting a digital input message m corresponding to control data used in a control channel through a communication channel (3), the message comprising a number B of bits, said method comprising:
- generating a binary code sequence from the B bits of the message, said binary code sequence comprising E' coded bits *fᵢ*;
- applying interleaving to said binary code sequence, which provides an interleaved binary code sequence comprising E bits *gᵢ*, with i = 0, 1 *... , E -* 1;
- applying inner coded modulation to a B'-bit information vector *uₗ* = 0,1, *... ,* 2*^{B'}* - 1, with *l* = 0,1, ... , *L -* 1, comprising *B'* bits taken in order from the interleaved binary code sequence *gᵢ* to provide a K-dimensional inner modulation code sequence comprising inner coded modulated vectors *c_{l,k}*, with *k =* 0,1, ... , *K -* 1, representing frequency-domain samples;
- applying single-carrier or multi-carrier modulation to the inner modulation code sequence *cₗ* to provide a modulated sequence x(m),
the method comprising transmitting said modulated sequence x(m) over the communication channel using transmit antennas,
wherein the step of applying inner coded modulation comprises a vector construction, said vector construction comprising creating said B'-bit information vector u*ₗ* from the interleaved binary code bits g*ᵢ*, and a generation of a non-coherent code sequence **y***ₗ* from the received *B*'-bit message **u***ₗ* and the parameter *K*, said non-coherent code sequence **y***ₗ* representing a modulated sequence of *K* samples, said *K* samples being complex numbers determined from a given alphabet,
**characterised in that**
the vector construction further comprises creating the *B*'-bit information vector **u***ₗ* by taking *B'* bits in order from the sequence *gᵢ* with *i* = 0, 1 ... , *E* - 1, and said non-coherent code sequence generation comprises generating the non-coherent code sequence as : ${y}_{l} = {u}_{l} ′ G$
where **u***ₗ'* depends on **u*ₗ*** and **G** represents a generator matrix of a non-coherent block code.

## Patentansprüche

1. Sendevorrichtung (1) zum Übertragen einer digitalen Eingangsnachricht m, die Steuerdaten, die in einem Steuerkanal verwendet werden, entspricht, über einen Kommunikationskanal (3), wobei die Sendevorrichtung (1) einen Satz von Sendeantennen umfasst, die Nachricht eine Anzahl B von Bits umfasst, wobei die Sendevorrichtung Folgendes umfasst:
- einen Binärcodegenerator (10), der so konfiguriert ist, dass er aus den B Bits der Nachricht eine Binärcodesequenz erzeugt, wobei die Binärcodesequenz E' codierte Bits *fᵢ* umfasst;
- einen binären Verschachteler (11), der so konfiguriert ist, dass er eine Verschachtelung auf die Binärcodesequenz anwendet, die einen verschachtelten Binärcode bereitstellt, der E Bits *gᵢ* umfasst, wobei i = 0, 1 ... , *E* - 1;
- eine innere codierte Modulationseinheit (12), die so konfiguriert ist, dass sie eine innere codierte Modulation auf einen B'-Bit-Informationsvektor *uₗ* = 0,1, ..., 2*^{B'}* - 1 , *l* = 0,1, ... , *L -* 1, umfassend *B'* Bits aus der verschachtelten Binärcodesequenz *cₗ*, anwendet, um eine K-dimensionale innere Modulationscodesequenz bereitzustellen, die innere codierte modulierte Vektoren *c_{l,k}* umfasst, wobei *k =* 0,1, ... , *K -* 1 Frequenzbereichsabtastwerte darstellen, wobei der B'-Bit-Informationsvektor *uₗ* einer Nachricht *mₗ* = 0,1, ..., 2*^{B'}* - 1 entspricht;
- einen oder mehrere Modulatoren (14), die so konfiguriert sind, dass sie eine Einzelträger- oder Mehrträgermodulation auf die innere Modulationscodesequenz *cₗ* anwenden, um eine modulierte Sequenz x(m) bereitzustellen, wobei die Sendevorrichtung so konfiguriert ist, dass sie die modulierte Sequenz über den Kommunikationskanal unter Verwendung der Sendeantennen überträgt,
wobei die innere codierte Modulationseinheit (12) eine Vektorkonstruktionseinheit (110) umfasst, die so konfiguriert ist, dass sie den *B*'-Bit-Informationsvektor u*ₗ* aus den verschachtelten Binärcodebits *gᵢ*, erstellt, und einen Blockcodegenerator (121), der so konfiguriert ist, dass er eine nicht-kohärente Codesequenz **y***ₗ* aus dem *B*'-Bit-Informationsvektor u*ₗ* und dem Parameter *K* generiert, wobei der nicht-kohärente Code **y***ₗ* eine modulierte Sequenz von *K* Abtastwerten darstellt, wobei die *K* Abtastwerte komplexe Zahlen sind, die aus einem gegebenen Alphabet bestimmt werden,
**dadurch gekennzeichnet, dass**
die Vektorkonstruktionseinheit (110) ferner so konfiguriert ist, dass sie den *B*'-Bit-Informationsvektor **u***ₗ* erstellt, indem sie die *B'* Bits der Reihe nach aus der Sequenz *gᵢ* am Ausgang des binären Verschachtelers (11) entnimmt, und der Blockcodegenerator (121) so konfiguriert ist, dass er die nicht-kohärente Codesequenz generiert als: ${y}_{l} = {u}_{l} ′ G$
wobei **u***ₗ'* von **u*ₗ*** abhängt und **G** eine Generatormatrix eines nicht-kohärenten Blockcodes darstellt.

2. Sendevorrichtung (1) nach Anspruch 1, wobei der binäre Verschachteler (11) so konfiguriert ist, dass er sicherstellt, dass E/B' benachbarte codierte Bits in der Binärcodesequenz regelmäßig über E/B' verschiedene Vektoren des inneren Modulationscodes verteilt sind.

3. Sendevorrichtung (1) nach Anspruch 2, wobei ein Bit *gᵢ* der verschachtelten Binärcodesequenz wie folgt bestimmt wird: ${g}_{i} = {f}_{\left(iB′modE\right) + \left⌊i/\left(\frac{E}{B ′}\right)\right⌋} ,$

4. Sendevorrichtung (1) nach einem vorstehenden Anspruch, wobei das Alphabet ein Einheitswurzelalphabet ist, wie beispielsweise ein QPSK-Alphabet oder ein BPSK-Alphabet.

5. Sendevorrichtung (1) nach einem vorstehenden Anspruch, wobei das Alphabet ein BPSK-Alphabet ist und der Vektor **u***ₗ'* definiert ist als: ${u}_{l} ′ = {u}_{l}$

6. Sendevorrichtung (1) nach einem der vorstehenden Ansprüche 1 bis 4, wobei das Alphabet ein QPSK-Alphabet ist und wobei für gerade Werte von *B*' der Vektor **u***ₗ'* definiert ist als: ${u}_{l} ′ \left(i\right) = 2 {u}_{l} \left(2i\right) + {u}_{l} \left(2i+1\right) ,$ wobei $0 \leq i < \frac{B ′}{2} .$

7. Sendevorrichtung (1) nach einem der vorstehenden Ansprüche 1 bis 4, wobei das Alphabet ein QPSK-Alphabet ist und wobei für ungerade Werte von *B*' der Vektor **u***ₗ'* definiert ist als: ${u}_{l} ′ \left(i\right) = \left\{\begin{matrix}2 {u}_{l} \left(2i\right) + {u}_{l} \left(2i+1\right) , & 0 \leq i < \left⌊\frac{B ′}{2}\right⌋ \\ 2 {u}_{l} \left(2i\right) & i = \left⌊\frac{B ′}{2}\right⌋\end{matrix}\right.$

8. Sendevorrichtung (1) nach einem vorstehenden Anspruch, wobei die innere codierte Modulationseinheit (12) ferner einen inneren Modulator (122) umfasst, der so konfiguriert ist, dass er jeden codierte Vektor **y***ₗ* moduliert, um die *K*-dimensionale innere Modulationscodesequenz c*ₗ* bereitzustellen, wobei die *K*-dimensionale innere Modulationscodesequenz c*ₗ* aus der nicht-kohärenten Codesequenz **y***ₗ* bestimmt wird.

9. Sendevorrichtung (1) nach Anspruch 8, wobei das Alphabet ein BPSK-Alphabet ist und die inneren codierten modulierten Vektoren *c_{l,k}* der *K*-dimensionalen inneren Modulationscodesequenz c*ₗ* bestimmt sind als: ${c}_{l , k} = 2 {y}_{l , k} - 1 ,$ oder ${c}_{l , k} = 1 - 2 {y}_{l , k} ,$ wobei $k = 0 , 1 , … , K - 1$

10. Sendevorrichtung (1) nach Anspruch 8, wobei das Alphabet ein QPSK-Alphabet ist und die inneren codierten modulierten Vektoren *c_{l,k}* der *K*-dimensionalen inneren Modulationscodesequenz c*ₗ* bestimmt sind als: ${c}_{l , k} = {e}^{γ \sqrt{- 1}} \sqrt{{\left(-1\right)}^{{y}_{l , k}}} ,$ wobei *γ* eine reelle Konstante ist und *k =* 0,1, *... , K -* 1.

11. Sendevorrichtung (1) nach einem vorstehenden Anspruch 8 bis 10, wobei die innere codierte Modulationseinheit (12) ferner ein Verarbeitungsmodul (124) umfasst, das konfiguriert ist zum:
- Gruppieren *K' = KL*/*S* benachbarter Abtastwerte *c_{l,k},* um Zwischenvektoren *v*_{*k'*,*s*} von Länge *L* Abtastwerten zu bestimmen, wobei ' = 0,1, ... , *K'* - 1 und *s* = 0,1, ... , *S -* 1;
- Bestimmen der inneren codierten modulierten Vektoren *c_{l,k}* aus dem entsprechenden Zwischenvektor *v*_{*k'*,*s*} und einem Phasorterm *φ_{k'}*, der von *k'* abhängt.

12. Sendevorrichtung (1) nach Anspruch 11, wobei der Zwischenvektor *v_{k',l}* definiert ist als: ${v}_{k ′ , s} = {c}_{\left⌊\frac{k ′ + sK ′}{K}\right⌋ , \left(k′+sK′\right) mod K}$

13. Verfahren zum Übertragen einer digitalen Eingangsnachricht m, die Steuerdaten, die in einem Steuerkanal verwendet werden, entspricht, über einen Kommunikationskanal (3), wobei die Nachricht eine Anzahl B von Bits umfasst, wobei das Verfahren Folgendes umfasst:
- Generieren einer Binärcodesequenz aus den *B* Bits der Nachricht, wobei die Binärcodesequenz *E*' codierte Bits *fᵢ* umfasst;
- Anwenden einer Verschachtelung auf die Binärcodesequenz, die eine verschachtelte Binärcodesequenz bereitstellt, die *E* Bits *gᵢ* umfasst, wobei i = 0, 1 ... , *E* - 1;
- Anwenden einer inneren codierten Modulation auf einen *B*'-Bit-Informationsvektor *uₗ =* 0,1, ..., 2*^{B'}* - 1, wobei *l =* 0,1, ... , *L -* 1, umfassend *B'* Bits, die der Reihe nach aus der verschachtelten Binärcodesequenz *gᵢ* entnommen werden, um eine K-dimensionale innere Modulationscodesequenz bereitzustellen, die innere codierte modulierte Vektoren *c_{l,k}* umfasst, wobei *k =* 0,1, ... , *K -* 1, die Frequenzbereichsabtastwerte darstellen;
- Anwenden einer Einzelträger- oder Mehrträgermodulation auf die innere Modulationscodesequenz *cₗ*, um eine modulierte Sequenz x(m) bereitzustellen,
wobei das Verfahren Übertragen der modulierten Sequenz x(m) über den Kommunikationskanal unter Verwendung von Sendeantennen umfasst,
wobei der Schritt zum Anwenden der inneren codierten Modulation eine Vektorkonstruktion umfasst, wobei die Vektorkonstruktion Erstellen des *B*'-Bit-Informationsvektors u*ₗ* aus den verschachtelten Binärcodebits g*ᵢ*, und eine Generierung einer nicht-kohärenten Codesequenz **y***ₗ* aus der empfangenen B'-Bit-Nachricht **u***ₗ* und dem Parameter *K* umfasst, wobei die nicht-kohärente Codesequenz **y***ₗ* eine modulierte Sequenz von *K* Abtastwerten darstellt, wobei die *K* Abtastwerte komplexe Zahlen sind, die aus einem gegebenen Alphabet bestimmt werden,
**dadurch gekennzeichnet, dass**
die Vektorkonstruktion ferner Erstellen des *B*'-Bit-Informationsvektors **u***ₗ* durch Entnehmen von *B'* Bits der Reihe nach aus der Sequenz *gᵢ*, wobei *i* = 0, 1 ... , *E* - 1, umfasst und die Generierung der nicht-kohärenten Codesequenz Generieren der nicht-kohärenten Codesequenz als ${y}_{l} = {u}_{l} ′ G$
umfasst, wobei **u***ₗ'* von ***uₗ*** abhängt und **G** eine Generatormatrix eines nicht-kohärenten Blockcodes darstellt.

## Revendications

1. Dispositif émetteur (1) destiné à transmettre un message d'entrée numérique m correspondant à des données de commande utilisées dans un canal de commande via un canal de communication (3), le dispositif émetteur (1) comprenant un ensemble d'antennes d'émission, le message comprenant un certain nombre B de bits, ledit dispositif émetteur comprenant :
- un générateur de code binaire (10) configuré pour générer une séquence de code binaire à partir des *B* bits du message, ladite séquence de code binaire comprenant E' bits codés *fᵢ* ;
- un entrelaceur binaire (11) configuré pour appliquer un entrelacement à ladite séquence de code binaire, qui fournit un code binaire entrelacé comprenant E bits *gᵢ* avec *i* = 0, 1 ... , *E* - 1;
- une unité de modulation codée interne (12) configurée pour appliquer une modulation codée interne à un vecteur d'information de *B'* bits *uₗ =* 0,1, ... , 2*^{B'}* - 1, *l =* 0,1, ... , *L -* 1comprenant *B'* bits extraits de la séquence de code binaire entrelacé *cₗ*, pour fournir une séquence de code de modulation interne à K dimensions comprenant des vecteurs modulés codés internes *c_{l,k},* avec *k =* 0, 1, ... , *K* - 1représentant des échantillons dans le domaine fréquentiel, ledit vecteur d'information de B'bits *uₗ* correspondant à un message *mₗ* = 0,1, ..., 2*^{B'}* - 1 ;
- un ou plusieurs modulateurs (14) configurés pour appliquer une modulation à porteuse unique ou à porteuses multiples à la séquence de code de modulation interne *cₗ* pour fournir une séquence modulée x(m), le dispositif émetteur étant configuré pour transmettre ladite séquence modulée sur le canal de communication en utilisant lesdites antennes d'émission,
dans lequel l'unité de modulation codée interne (12) comprend une unité de construction vectorielle (110) configurée pour créer ledit vecteur d'information à B'bits u*ₗ* à partir des bits de code binaire entrelacé *gᵢ*, et un générateur de code par blocs (121) configuré pour générer une séquence de code non cohérent **y***ₗ* à partir du vecteur d'information à *B*' bits u*ₗ* et du paramètre *K,* ledit code non cohérent **y***ₗ* représentant une séquence modulée de *K* échantillons, lesdits *K* échantillons étant des nombres complexes déterminés à partir d'un alphabet donné,
**caractérisé en ce que**
l'unité de construction vectorielle (110) est configurée en outre pour créer le vecteur d'information à *B'* bits **u***ₗ* en prenant les *B'* bits dans l'ordre de la séquence *gᵢ* au niveau de la sortie de l'entrelaceur binaire (11) et le générateur de code par blocs (121) est configuré pour générer la séquence de code non cohérent comme : ${y}_{l} = {u}_{l} ′ G$
où **u***_{l'}* dépend de ***uₗ*** et **G** représente une matrice génératrice d'un code par blocs non cohérent.

2. Dispositif émetteur (1) selon la revendication 1, dans lequel l'entrelaceur binaire (11) est configuré pour garantir que E/B' bits codés adjacents dans la séquence de code binaire sont répartis régulièrement sur E/B' vecteurs différents du code de modulation interne.

3. Dispositif émetteur (1) selon la revendication 2, dans lequel un bit *gᵢ* de la séquence de code binaire entrelacé est déterminé comme : ${g}_{i} = {f}_{\left(iB′modE\right) + \left⌊i/\left(\frac{E}{B ′}\right)\right⌋} ,$

4. Dispositif émetteur (1) selon une quelconque revendication précédente, dans lequel l'alphabet est un alphabet de racines de l'unité, tel qu'un alphabet QPSK ou un alphabet BPSK.

5. Dispositif émetteur (1) selon une quelconque revendication précédente, dans lequel l'alphabet est un alphabet BPSK et le vecteur **u***ₗ'* est défini comme : ${u}_{l} ′ = {u}_{l}$

6. Dispositif émetteur (1) selon l'une quelconque des revendications 1 à 4 précédentes, dans lequel l'alphabet est un alphabet QPSK et, dans lequel, pour des valeurs paires de *B',* le vecteur **u***ₗ'* est défini comme : ${u}_{l} ′ \left(i\right) = 2 {u}_{l} \left(2i\right) + {u}_{l} \left(2i+1\right) ,$ avec $0 \leq i < \frac{B ′}{2} .$

7. Dispositif émetteur (1) selon une quelconque revendication 1 à 4 précédente, dans lequel l'alphabet est un alphabet QPSK et dans lequel, pour des valeurs impaires de *B',* le vecteur **u***ₗ'* est défini comme : ${u}_{l} ′ \left(i\right) = \left\{\begin{matrix}2 {u}_{l} \left(2i\right) + {u}_{l} \left(2i+1\right) , & 0 \leq i < \left⌊\frac{B ′}{2}\right⌋ \\ 2 {u}_{l} \left(2i\right) & i = \left⌊\frac{B ′}{2}\right⌋\end{matrix}\right.$

8. Dispositif émetteur (1) selon une quelconque revendication précédente, dans lequel l'unité de modulation codée interne (12) comprend en outre un modulateur interne (122) configuré pour moduler chaque vecteur codé **y***ₗ* pour fournir ladite séquence de code de modulation interne [ *K* dimensionnelle *cₗ*, la séquence de code de modulation interne *K*-dimensionnelle c*ₗ* étant déterminée à partir de la séquence de code non cohérente**y***ₗ*.

9. Dispositif émetteur (1) selon la revendication 8, dans lequel l'alphabet est un alphabet BPSK et les vecteurs modulés codés internes *c_{l,k}* de la séquence de code de modulation interne *K-*dimensionnelle c*ₗ* sont déterminés comme : ${c}_{l , k} = 2 {y}_{l , k} - 1 ,$ ou ${c}_{l , k} = 1 - 2 {y}_{l , k} ,$ avec $k = 0 , 1 , … , K - 1$

10. Dispositif émetteur (1) selon la revendication 8, dans lequel l'alphabet est un alphabet QPSK et les vecteurs modulés codés internes *c_{l,k}* de la séquence de code de modulation interne *K-*dimensionnelle c*ₗ* sont déterminés comme : ${c}_{l , k} = {e}^{γ \sqrt{- 1}} \sqrt{{\left(-1\right)}^{{y}_{l , k}}} ,$ où *γ* est une constante réelle et *k =* 0, 1, ... , *K -* 1.

11. Dispositif émetteur (1) selon une quelconque revendication 8 à 10 précédente, dans lequel l'unité de modulation codée interne (12) comprend en outre un module de traitement (124) configuré pour :
- grouper des *K' = KL*/*S* échantillons adjacents *c_{l,k}* pour déterminer des vecteurs intermédiaires *v*_{*k'*,*s*} d'échantillons de longueur *L,* avec' = 0, 1, ..., *K*' - 1 et *s* = 0 ,1, ... , *S* - 1 ;
- déterminer les vecteurs modulés codés internes *c_{l,k}* à partir du vecteur intermédiaire correspondant *v*_{*k*',*s*} et d'un terme de phaseur *φ_{k'}* qui dépend de *k'.*

12. Dispositif émetteur (1) selon la revendication 11, dans lequel le vecteur intermédiaire *v_{k',l}* est défini comme : ${v}_{k ′ , s} = {c}_{\left⌊\frac{k ′ + sK ′}{K}\right⌋ , \left(k′+sK′\right) mod K}$

13. Procédé de transmission d'un message d'entrée numérique m correspondant à des données de commande utilisées dans un canal de commande via un canal de communication (3), le message comprenant un nombre *B* de bits, ledit procédé comprenant :
- la génération d'une séquence de code binaire à partir des *B* bits du message, ladite séquence de code binaire comprenant *E'* bits codés *fᵢ* ;
- l'application de l'entrelacement à ladite séquence de code binaire, ce qui fournit une séquence de code binaire entrelacé comprenant *E* bits *gᵢ*, avec i = 0, 1 ... , *E* - 1 ;
- l'application d'une modulation codée interne à un vecteur d'information à *B*'-bits *uₗ =* 0, 1, ..., 2*^{B'} -* 1, avec *l* = 0, 1, ... , *L -* 1, comprenant *B'* des bits pris dans l'ordre de la séquence de code binaire entrelacé *gᵢ* pour fournir une séquence de code de modulation interne K-dimensionnelle comprenant des vecteurs modulés codés internes *c_{l,k}*, avec *k =* 0,1, *.*.. , *K -* 1, représentant des échantillons dans le domaine fréquentiel ;
- l'application d'une modulation à porteuse unique ou à porteuses multiples à la séquence de code de modulation interne *cₗ* pour fournir une séquence modulée x(m),
Procédé comprenant la transmission de ladite séquence modulée x(m) sur le canal de communication à l'aide d'antennes d'émission,
dans lequel l'étape d'application d'une modulation codée interne comprend une construction vectorielle, ladite construction vectorielle comprenant la création dudit vecteur d'information à *B*'-bits u*ₗ* à partir des bits de code binaire entrelacé g*ᵢ*, et une génération d'une séquence de code non cohérent **y***ₗ* à partir du message à *B*'-bits reçu **u***ₗ* et du paramètre *K*, ladite séquence de code non cohérent **y***ₗ* représentant une séquence modulée de *K* échantillons, lesdits *K* échantillons étant des nombres complexes déterminés à partir d'un alphabet donné,
**caractérisé en ce que**
la construction vectorielle comprend en outre la création du vecteur d'information à *B*'bits **u***ₗ* en prenant *B'* bits dans l'ordre de la séquence *gᵢ* avec *i =* 0, 1 ... , *E* - 1 et ladite génération de séquence de code non cohérent comprend la génération de la séquence de code non cohérent comme : ${y}_{l} = {u}_{l} ′ G$
où **u***ₗ'* dépend de **u*ₗ*** et **G** représente une matrice génératrice d'un code par blocs non cohérent.
